# EUROPEAN PATENT APPLICATION

(11) **EP 4 443 480 A1**
(43) Date of publication of application: **09.10.2024**
(21) Application number: 23192852.4
(22) Date of filing: 23.08.2023
(51) Int. Cl.: H01L 21/56, H01L 23/051, H01L 23/31, H01L 25/07, H01L 25/00, H01L 23/373, H01L 23/498

(54) **POWER SEMICONDUCTOR MODULE, POWER CONVERTER INCLUDING THE SAME AND MANUFACTURING METHOD OF POWER SEMICONDUCTOR MODULE**

(30) Priority: 05.04.2023 KR 20230044992
(71) Applicant: LX Semicon Co., Ltd., Daejeon 34027 (KR)
(72) Inventor: MOON, Dongwoo, 34027 Daejeon (KR); KIM, Deogsoo, 34027 Daejeon (KR); KIM, Taeryong, 34027 Daejeon (KR)
(74) Representative: Ter Meer Steinmeister & Partner

(57) **Abstract**

The embodiment relates to a power semiconductor module and a power converter including the same. A power semiconductor module according to an embodiment can include a first substrate and a second substrate, a sub-module disposed between the first substrate and the second substrate and a first conductive frame and a second conductive frame electrically connected to the sub-module. The sub-module can include a power semiconductor device disposed between a first internal conductive frame and a second internal conductive frame and a first mold disposed between the first internal conductive frame and the second internal conductive frame, and disposed on a side surface of the power semiconductor device.

## Description

### The Background

### 1. The field

The embodiment relates to a power semiconductor module, a power converter including the same and Manufacturing method of power semiconductor module.

### 2. Description of the related art

Power semiconductors are one of the key factors that determine the efficiency, speed, durability and reliability of power electronic systems.

With the recent development of the power electronics industry, as the previously used silicon (Si) power semiconductors reach their physical limits, research on WBG (Wide Bandgap) power semiconductors such as silicon carbide (SiC) and gallium nitride (GaN) to replace Si power semiconductors is being actively conducted.

WBG power semiconductor devices have bandgap energy about 3 times that of Si power semiconductor devices, resulting in low intrinsic carrier concentration, high dielectric breakdown field (about 4 to 20 times), and high thermal conductivity (about 3 to 13 times) and a large electron saturation rate (about 2 to 2.5 times).

Due to these characteristics, it can operate in a high-temperature, high-voltage environment and has high switching speed and low switching loss. Among them, a gallium nitride (GaN) power semiconductor device can be used for a low voltage system, and a silicon carbide (SiC) power semiconductor device can be used for a high voltage system.

On the other hand, according to the internal technology related to SiC power semiconductors, there is a problem in that power semiconductor devices are cracked in the process of bonding individual power semiconductor devices to a predetermined heat dissipation substrate.

In addition, in the internal technology, there is a problem in that voids exist because the mold material is not properly filled in the molding process after attaching the individual power semiconductor devices to the heat dissipation substrate.

In addition, in the internal technology, there is a problem in that electrical interconnection defects occur between the electrodes of the power semiconductor device and the conductive layer pattern of the heat dissipation substrate in the process of bonding individual power semiconductor devices to the heat dissipation substrate.

In addition, according to the internal technology, a plurality of semiconductor modules each including a plurality of power semiconductor devices can be manufactured as one unit module. However, when a failure occurs in the final module test, there is a problem in that the entire manufactured unit module must be discarded.

### The Summary

One of the technical objects of the embodiment is to solve the problem of power semiconductor devices being cracked in the process of attaching individual power semiconductor devices to a predetermined heat dissipation substrate.

In addition, one of the technical objects of the embodiment is to solve the problem of the presence of voids because the mold material is not properly filled in the molding process after attaching the individual power semiconductor devices to the heat dissipation substrate.

In addition, one of the technical objects of the embodiment is to solve the problem of electrical interconnection failure between the electrodes of the power semiconductor device and the conductive layer pattern of the heat dissipation substrate in the process of bonding individual power semiconductor devices to the heat dissipation substrate.

In addition, one of the technical objects of the embodiment is to solve the problem of discarding the entire manufactured unit module when a failure occurs in a final module test after a plurality of semiconductor modules are manufactured as one unit module.

One or more of these objects are solved by the features of the independent claims. The technical objects of the embodiments are not limited to those described in this section, but include those that can be understood through the description of the invention.

Solutions for solving the technical problem of the embodiments can include any one of the following.

A power semiconductor module according to an embodiment includes a first substrate and a second substrate, a sub-module disposed between the first substrate and the second substrate and a first conductive frame and a second conductive frame electrically connected to the sub-module. The first and second conductive frames may be referred to as first and second lead frames, but are not limited thereto. Also, the sub-module may be referred to as a power semiconductor sub-module, but is not limited thereto.

The sub-module may include a power semiconductor device disposed between a first internal conductive frame and a second internal conductive frame. The sub-module may include a first mold disposed between the first internal conductive frame and the second internal conductive frame, and/or disposed on a side surface of the power semiconductor device. The first mold may be referred to as an internal mold, but is not limited thereto.

The power semiconductor device may include first and second power semiconductor devices, the first internal conductive frame may include a first-first internal conductive frame and a first-second internal conductive frame spaced apart each other.

The first-first internal conductive frame may be electrically connected to a drain electrode of the first power semiconductor device.

The first-second internal conductive frame may be electrically connected to a source electrode and a gate electrode of the second power semiconductor device.

The second internal conductive frame may be electrically connected to a gate electrode and a source electrode of the first power semiconductor device, and/or electrically connected to a drain electrode of the second power semiconductor device.

The first substrate may include a first metal layer, a first insulating layer, and a second metal layer sequentially disposed.

The second metal layer may include a second-first metal layer and a second-second metal layer electrically separated from each other.

Each of the second-first metal layer and the second-second metal layer may be electrically connected to each of the first-first internal conductive frame and the first-second internal conductive frame spaced apart from each other of the sub-module.

Each of the second-first metal layer and the second-second metal layer may be in contact with the first-first internal conductive frame and the first-second internal conductive frame spaced apart from each other of the sub-module.

The second substrate may include a third metal layer, a second insulating layer, and a fourth metal layer sequentially disposed.

The third metal layer may be electrically connected to the second internal conductive frame of the sub-module.

The third metal layer may be in contact with the second internal conductive frame of the sub-module.

The first conductive frame and the second conductive frame may be electrically connected to the sub-module through the first substrate and the second substrate, respectively.

The first conductive frame may include a first-first conductive frame electrically connected to the second-first metal layer of the first substrate, and/or a first-second conductive frame electrically connected to the third metal layer of the second substrate.

The second conductive frame may include a second-first conductive frame electrically connected to the second-second metal layer of the first substrate, and/or a second-second conductive frame electrically connected to the third metal layer of the second substrate.

Further, the power semiconductor module may include a second mold surrounding an outer surface of the sub-module. The second mold may be referred to as an outer mold, but is not limited thereto.

A power semiconductor module according to another embodiment includes a first substrate and a second substrate, a sub-module disposed between the first substrate and the second substrate, a first conductive frame and a second conductive frame electrically connected to the sub-module and a second mold disposed on an outer surface of the sub-module.

The sub-module may include a power semiconductor device disposed on a first internal conductive frame and a first mold disposed on a side surface of the power semiconductor device.

The power semiconductor device may include first and second power semiconductor devices and the first internal conductive frame may be electrically connected to a source electrode, a gate electrode of each of the first power semiconductor device, second power semiconductor device.

Further, the power semiconductor module may include a second internal conductive frame disposed on the first and second power semiconductor devices. The second internal conductive frame may be electrically connected to a drain electrode of each of the first power semiconductor device or the second power semiconductor device.

Each of the first conductive frame and the second conductive frame may be electrically connected to the sub-module by the first substrate and the second substrate, respectively

The first conductive frame may include a first-first conductive frame electrically connected to a metal layer of the first substrate and/or a first-second conductive frame electrically connected to a metal layer of the second substrate.

The second conductive frame may include a second-first conductive frame electrically connected to the metal layer of the first substrate and/or a second-second conductive frame electrically connected to the metal layer of the second substrate.

A power converter may include any one of the power semiconductor modules as above.

Also, a manufacturing method of a power semiconductor module, the manufacturing method may include forming a first substrate, forming a molded sub-module on a top of the first substrate, forming a second substrate on a top of the molded sub-module, electrically connecting a first conductive frame to the molded sub-module and electrically connecting a second conductive frame to the molded sub-module.

The molded sub-modules may include a first internal conductive frame, a second internal conductive frame, a semiconductor device disposed between the first internal conductive frame and the second internal conductive frame and a first mold disposed between the first, second internal conductive frames and on a side surface of the semiconductor device.

Technical effects of the power semiconductor module and the power converter including the same according to the embodiment may include any of the following.

According to the power semiconductor module and the power converter including the power semiconductor module according to the embodiment, it is possible to solve the problem of cracking of power semiconductor devices in the process of attaching individual power semiconductor devices to a heat dissipation substrate.

For example, in the embodiment, a plurality of power semiconductor devices can be formed into a sub module using an internal conductive frame, and the internal conductive frame can be bonded to a heat dissipation board in the sub module state, so there are technical effects of solving the problem of cracking of the power semiconductor device.

In addition, according to the embodiment, it is possible to solve the problem that voids exist because the mold material is not properly filled in the molding process after attaching the individual power semiconductor devices to the heat dissipation substrate.

For example, in the embodiment, since first molding can be performed in the sub-module stage using an internal conductive frame, there is a technical effect of solving the problem of having voids inside.

In addition, according to the embodiment, it is possible to solve the problem of electrical interconnection failure between the electrodes of the power semiconductor device and the conductive layer pattern of the heat dissipation substrate in the process of attaching the individual power semiconductor devices to the heat dissipation substrate.

For example, the embodiment can proceed with sub modulation using an internal conductive frame. Accordingly, the internal conductive frame in the sub-module state can be adhered to the conductive layer pattern of the heat dissipation substrate. Therefore, there is a technical effect of solving the problem of electrical interconnection failure between the electrodes of the power semiconductor device and the conductive layer pattern of the heat dissipation substrate.

In addition, according to the embodiment, it is possible to solve the problem of discarding all manufactured unit modules when a failure occurs in a final module test after a plurality of semiconductor modules are manufactured as one unit module.

For example, in the embodiment, a plurality of power semiconductor devices can be serialized or parallelized into submodules according to module specifications, and only failed submodules can be discarded through pre-testing of the submodules. Therefore, there is a technical effect in that cost can be reduced and mass production can be increased.

In addition, a sub-module according to a second embodiment can have a technical effect of securing a wide second gate electrode area. For example, a width of one side of a second gate electrode area can be secured four times or more than that of a first gate area or the second gate area. Accordingly, there is a special technical effect of securing a gate electrode area 16 times or more in the second gate electrode area compared to the internal technology.

The technical effects of the embodiments are not limited to those described in this section, but include those that can be understood through the description of the invention.

### Brief description of the drawings

FIG. 1 is an exemplary view of a power converter 1000 according to an embodiment.
FIG. 2A is a first cross-sectional view of a power semiconductor device 100 according to an embodiment.
FIG. 2B is a second cross-sectional view of a power semiconductor device 100 according to an embodiment.
FIG. 3A is a first cross-sectional view of a power semiconductor module 500 according to an embodiment.
FIG. 3B is a second cross-sectional view of a power semiconductor module 500 according to an embodiment.
FIG. 3C is a third cross-sectional view of a power semiconductor module 500 according to an embodiment.
FIG. FIG. 3D is a detailed view of the sub-module 200 in the power semiconductor module 500 shown in FIG. 3C.
FIGS. 4A to 4G are exemplary views of a manufacturing process of a power semiconductor module 500 according to an embodiment.
FIG. 5A is an exemplary view of a sub-module manufacturing process according to a second embodiment;
FIG. 5B is an enlarged view of a second sub-module disposed on the first internal conductive frame shown in FIG. 5A.

### The Detailed description

Hereinafter, the invention according to an embodiment for solving the above problems will be described in more detail with reference to the drawings.

The suffixes "module" and "unit" for the elements used in the following description are simply given in consideration of ease of writing this specification, and do not themselves give a particularly important meaning or role. Accordingly, the "module" and "unit" can be used interchangeably.

Terms including ordinal numbers, such as first and second, can be used to describe various elements, but the elements are not limited by the terms. These terms are only used for the purpose of distinguishing one element from another.

Singular expressions include plural expressions unless the context clearly dictates otherwise.

In this application, terms such as "comprise", "have" or "include" are intended to designate that there is a feature, number, step, operation, component, part, or combination thereof described in the specification, and it is not precluded from being excluded one or other features, numbers, steps, operations, components, parts, or combinations thereof, or any combination thereof.

### (Embodiment)

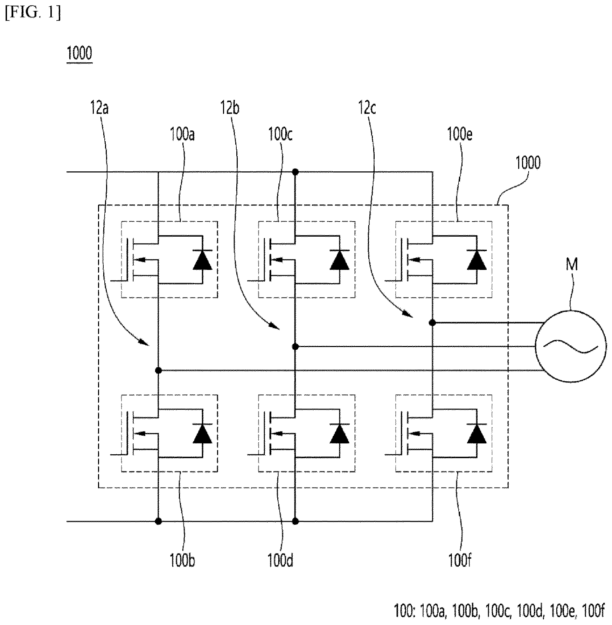

FIG. 1 is an exemplary view of a power converter 1000 according to an embodiment.

The power converter 1000 according to the embodiment can receive DC power from a battery or fuel cell, convert it into AC power, and supply AC power to a predetermined load. For example, the power converter 1000 according to the embodiment can include an inverter, which receive DC power from a battery, convert DC power into 3-phase AC power, and supply 3-phase AC power to a motor M. And motor M can provide power to electric vehicles or fuel cell vehicles.

The power converter 1000 according to the embodiment can include the power semiconductor device 100. The power semiconductor device 100 can be a Metal Oxide Semiconductor Field Effect Transistor (MOSFET), but is not limited thereto, and can include an Insulated Gate Bipolar Transistor (IGBT).

For example, the power converter 1000 can include a plurality of power semiconductor devices 100a, 100b, 100c, 100d, 100e, and 100f, and can include a plurality of diodes (not shown). Each of the plurality of diodes can be internally incorporated in each of the power semiconductor devices 100a, 100b, 100c, 100d, 100e, and 100f in the form of an internal diode, but is not limited thereto, and can be disposed separately.

In the embodiment, DC power can be converted into AC power through on-off control of the plurality of power semiconductor devices 100a to 100f.

For example, in the power converter 1000 according to the embodiment, the first power semiconductor device 100a can be turned on and the second power semiconductor device 100b can be turned off in a first time period of one cycle to supply positive polarity power to the motor M.

In addition, in the second time period of one cycle, the first power semiconductor device 100a can be turned off and the second power semiconductor device 100b can be turned on to supply negative polarity power to the motor M.

In the embodiment, a group of power semiconductor devices disposed in series in a high voltage line and a low voltage line of an input side can be referred to as an arm.

For example, the first power semiconductor device 100a and the second power semiconductor device 100b can constitute a first arm, and the third power semiconductor device 100c and the fourth power semiconductor device 100d can constitute a second arm. And the fifth power semiconductor device 100e and the sixth power semiconductor device 100f can constitute a third arm.

In the arm, an upper side power semiconductor device and a lower side power semiconductor device can be controlled not to turn on at the same time. For example, in the first arm, the first power semiconductor device 100a and the second power semiconductor device 100b do not simultaneously turn on, but can turn on and off alternately.

Each of the power semiconductor devices 100a to 100f can receive high power in an off state. For example, when the second power semiconductor device 100b is turned off while the first power semiconductor device 100a is turned on, the input voltage can be applied to the second power semiconductor device 100b as it is. The voltage input to the second power semiconductor device 100b can be a relatively high voltage, and a withstand voltage of each power semiconductor device 100a to 100f can be designed to have a high level to withstand such a high voltage.

Each of the power semiconductor devices 100a to 100f can conduct a high current in a turn on state. The motor M can be driven with a relatively high current, and this high current can be supplied to the motor M through a power semiconductor that is turned on.

A high voltage applied to each of the power semiconductor devices 100a to 100f can cause a high switching loss. A high current conducting the power semiconductor devices 100a to 100f can cause a high conduction loss. In order to dissipate heat generated by such switching loss or conduction loss, the power semiconductor devices 100a to 100f can be packaged as a power semiconductor module including a heat dissipation means.

The power semiconductor device 100 of the embodiment can be a silicon carbide (SiC) power semiconductor device, can operate in a high-temperature, high-voltage environment, and can have a high switching speed and low switching loss.

Meanwhile, the power converter 1000 according to the embodiment can include a plurality of power semiconductor modules.

For example, the plurality of power semiconductor devices 100a to 100f shown in FIG. 1 can be packaged into one power semiconductor module, or the power semiconductor devices constituting each arm can be packaged into one power semiconductor module.

For example, the first power semiconductor device 100a, the second power semiconductor device 100b, the third power semiconductor device 100c, the fourth power semiconductor device 100d, and the fifth power semiconductor device 100e and the sixth power semiconductor device 100f shown in FIG. 1 can be packaged into one power semiconductor module.

In addition, there can be additional power semiconductor devices disposed in parallel with each of the power semiconductor devices 100a to 100f to increase a current capacity. In this case, the number of power semiconductor devices included in the power semiconductor module can be greater than six.

The power converter 1000 according to the embodiment can include a diode-type power semiconductor device in addition to the transistor-type power semiconductor devices 100a to 100f. For example, a first diode (not shown) can be disposed in parallel with the first power semiconductor device 100a, and a second diode (not shown) can be disposed in parallel with the second power semiconductor device 100b. Also, these diodes can be packaged together in one power semiconductor module. In addition, the diode can be disposed in the form of an internal diode in each power semiconductor device.

Next, the power semiconductor devices constituting each arm can be packaged into one power semiconductor module.

For example, the first power semiconductor device 100a and the second power semiconductor device 100b constituting the first arm can be packaged as a first power semiconductor module. The third power semiconductor device 100c and the fourth power semiconductor device 100d constituting the second arm can be packaged into a second power semiconductor module. And the fifth power semiconductor device 100e and the sixth power semiconductor device 100f constituting the third arm can be packaged into a third power semiconductor module.

In addition, there can be additional power semiconductor devices arranged in parallel with each power semiconductor device 100a to 100f to increase a current capacity. In this case, the number of power semiconductor devices included in each power semiconductor module can be more than two. Also, each arm can include a diode-type power semiconductor device (not shown) in addition to the transistor-type power semiconductor devices 100a to 100f, and these diodes can also be packaged together in one power semiconductor module. In addition, the diode can be disposed in a form of an internal diode in each power semiconductor device.

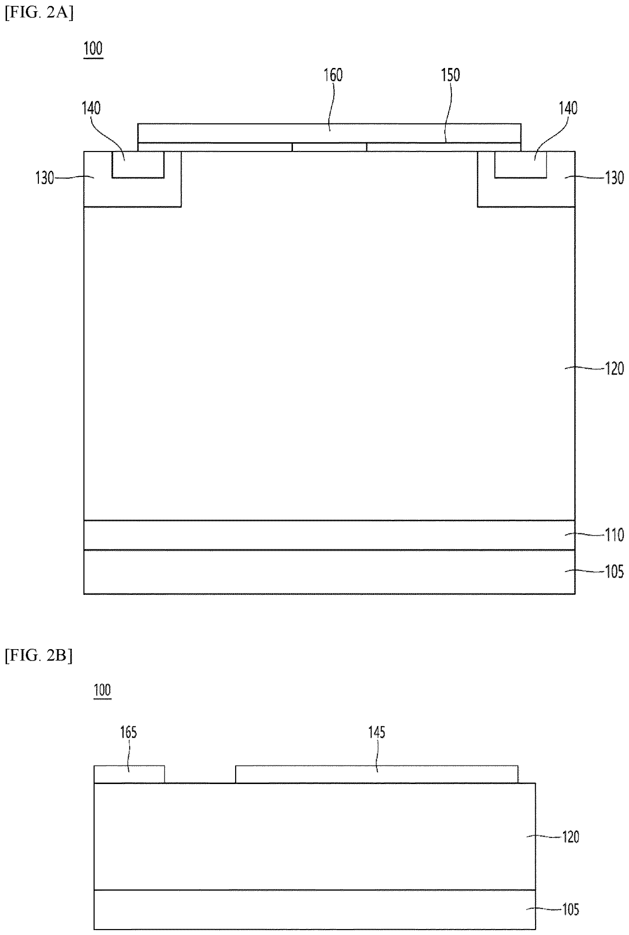

Next, FIG. 2A is a first cross-sectional view of the power semiconductor device 100 according to the embodiment.

Referring to FIG. 2A, a power semiconductor device 100 according to an embodiment can include a substrate 110, a first conductivity type epitaxial layer 120, a second conductivity type well 130, and a first conductivity type source region 140, a gate insulating layer 150, a gate electrode 160, and a drain electrode 105. The first conductivity type can be N-type, and the second conductivity type can be P-type, but is not limited thereto.

For example, the power semiconductor device 100 can include the first conductivity type epitaxial layer 120 disposed on a substrate 110 and the second conductivity type well 130 disposed on the first conductivity type epitaxial layer 120, the first conductivity type source region 140 disposed in the second conductivity type well 130, the gate insulating layer 150 and the gate electrode 160 disposed on the first conductivity type source region 140 and a drain electrode 105 disposed below the substrate 110.

The substrate 110 and the first conductive epitaxial layer 120 can include silicon carbide (SiC).

Next, FIG. 2B is a second cross-sectional view of the power semiconductor device 100 according to the embodiment, and is a schematic view based on the first cross-sectional view shown in FIG. 2A.

The power semiconductor device 100 according to the embodiment can include a source electrode 145 disposed above the semiconductor epitaxial layer 120, a gate electrode 165, and the drain electrode 105 disposed below the semiconductor epitaxial layer 120.

In a MOSFET according to the embodiment, the source electrode 145 or the gate electrode 165 can include an Al-based metal, and the drain electrode 105 can include Ti/Ni/Ag metal including a Ti layer, a Ni layer, or an Ag layer, or NiV / Ag, V (vanadium) / Ni / Ag, etc, but is not limited thereto.

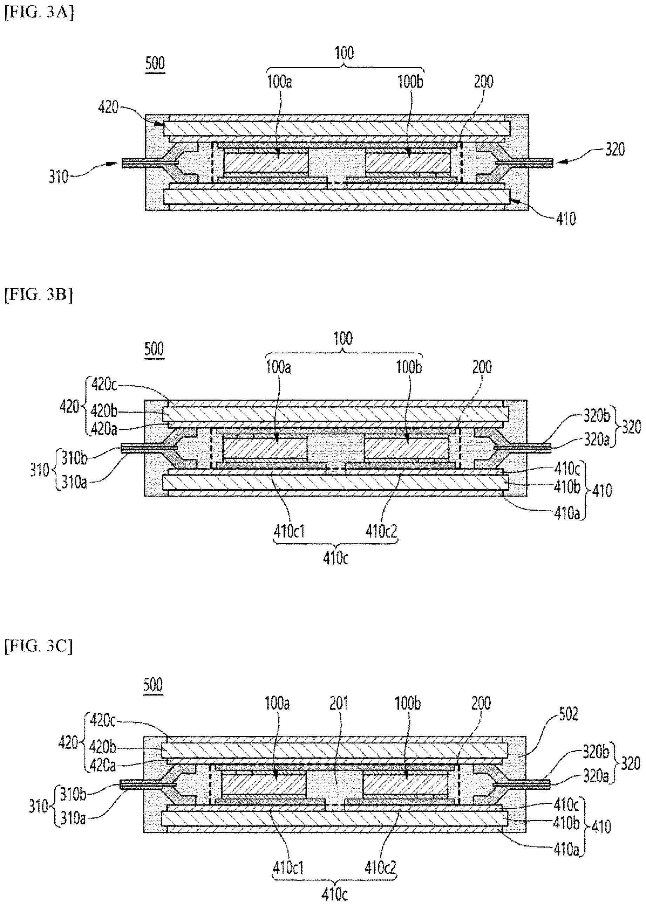

Next, FIG. 3A is a first cross-sectional view of the power semiconductor module 500 according to the embodiment.

The power semiconductor module 500 according to the embodiment can include a first substrate 410, a second substrate 420, a sub-module 200, a first conductive frame 310, and a second conductive frame 320.

The sub-module 200 can include a plurality of power semiconductor devices 100a and 100b.

For example, the sub-module 200 can include a first power semiconductor device 100a and a second power semiconductor device 100b. Referring to FIG. 2B for a moment, the first or second power semiconductor device 100a or 100b can include a semiconductor epitaxial layer 120, a source electrode 145, a gate electrode 165, and a drain electrode 105.

Referring back to FIG. 3A, the first power semiconductor device 100a and the second power semiconductor device 100b can constitute one arm.

For example, electrodes of the first power semiconductor device 100a and the second power semiconductor device 100b can be disposed in opposite directions. For example, a source electrode and a gate electrode of the first power semiconductor device 100a can be disposed upward, and a drain electrode thereof can be disposed downward.

Also, a source electrode and a gate electrode of the second power semiconductor device 100b can be disposed downward and a drain electrode thereof can be disposed upward. In this arrangement structure, the first power semiconductor device 100a and the second power semiconductor device 100b can constitute one arm.

Meanwhile, the first power semiconductor device 100a and the second power semiconductor device 100b can be electrically connected in parallel.

For example, in the embodiment, electrodes of the first power semiconductor device 100a and the second power semiconductor device 100b can be disposed in the same direction. For example, the source electrode and the gate electrode of the first power semiconductor device 100a can be disposed upward and the drain electrode can be disposed downward.

Also, the source electrode and the gate electrode of the second power semiconductor device 100b can be disposed upward and the drain electrode can be disposed downward. In this arrangement structure, the first power semiconductor device 100a and the second power semiconductor device 100b can be electrically connected in parallel.

Next, FIG. 3B is a second cross-sectional view of the power semiconductor module 500 according to the embodiment, and is a detailed view of the power semiconductor module 500 according to the embodiment shown in FIG. 3A.

In an embodiment, the first and second substrates 410 and 420 can be respectively disposed on the lower and upper sides of the power semiconductor module 500.

For example, the first substrate 410 can be disposed on a lower side of the power semiconductor module 500 and can be adhered to a lower side of the power semiconductor module 500 through a predetermined adhesive member (not shown). The adhesive member can be a SnAg-based adhesive member or an Ag-based adhesive member. Alternatively, the first substrate 410 can be attached to the lower side of the power semiconductor module 500 by soldering or sintering.

The second substrate 420 can be disposed on an upper side of the power semiconductor module 500, and the technical characteristics of the first substrate 410 described above can be adopted.

The first substrate 410 can include a first metal layer 410a, a first insulating layer 410b, and a second metal layer 410c.

The first insulating layer 410b can electrically insulate the first metal layer 410a and the second metal layer 410c. The first insulating layer 410b can include a ceramic material having high thermal conductivity.

One side of the first metal layer 410a can contact the first insulating layer 410b and dissipate heat to the other side. A heat dissipation unit including a cooling medium can be disposed adjacent to the other side of the first metal layer 410a.

A wiring pattern can be formed on the second metal layer 410c and the wiring pattern can be electrically connected to the sub-module 200.

For example, the second metal layer 410c can include a second-first metal layer 410c1 and a second-second metal layer 410c2 electrically separated which can be electrically connected to the first power semiconductor device 100a and the power semiconductor device 100b respectively. The first metal layer 410a and the second metal layer 410c can include a Cu-based metal, but are not limited thereto.

Also, the second substrate 420 can include a third metal layer 420a, a second insulating layer 420b, and a fourth metal layer 420c. The second substrate 420 can adopt technical features of the first substrate 410.

For example, the second insulating layer 420b can electrically insulate the third metal layer 420a and the fourth metal layer 420c. The second insulating layer 420b can include a ceramic material having high thermal conductivity.

A wiring pattern can be formed on the third metal layer 420a and the wiring pattern can be electrically connected to the sub-module 200. For example, the third metal layer 420a can be electrically connected to the first power semiconductor device 100a and the second power semiconductor device 100b.

One side of the fourth metal layer 420c can contact the second insulating layer 420b and dissipate heat to the other side. A heat dissipation unit including a cooling medium can be disposed adjacent to the other side of the fourth metal layer 420c.

Referring to FIG. 3B continuously, one side of each of the first conductive frame 310 and the second conductive frame 320 can be electrically connected to the sub-module 200, and the other side of each can be connected to an external connection terminal. The external connection terminal can include an input power source, a motor or an inverter controller, and the like.

For example, the first conductive frame 300 and the second conductive frame 320 can be electrically connected to the sub-module 200 through the first substrate 410 and the second substrate 420.

For example, the first conductive frame 310 can include a first-first conductive frame 310a electrically connected to the second-first metal layer 410c1 of the first substrate 410 and a second substrate 420. The first-second conductive frames 310b can be electrically connected to the third metal layer 420a.

In addition, the second conductive frame 320 can include the second-first conductive frame 320a electrically connected to the second-second metal layer 410c2 of the first substrate 410, and a second-second conductive frame 320b electrically connected to the metal layer 420a of the second substrate 420.

Next, FIG. 3C is a third cross-sectional view of the power semiconductor module 500 according to the embodiment, and is a detailed view of the power semiconductor module 500 according to the embodiment shown in FIG. 3B.

The sub-module 200 of the embodiment can include an inner mold 201 surrounding side surfaces of the plurality of power semiconductor devices 100a and 100b.

In addition, the power semiconductor module 500 according to the embodiment can include an second mold 502 surrounding an outer surface of the sub-module 200.

The inner mold 201 or the second mold 502 can include EMC (Epoxy Molding Compound), but is not limited to.

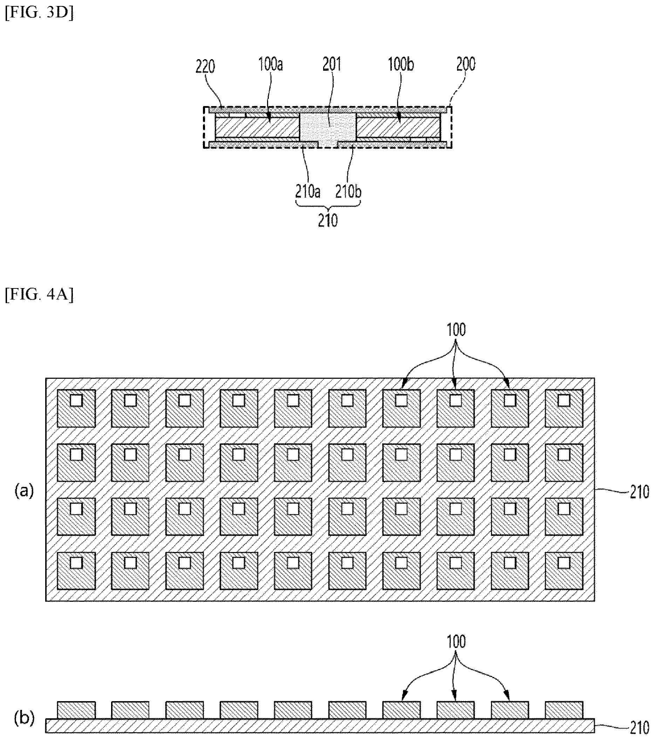

Next, FIG. 3D is a detailed view of the sub-module 200 in the power semiconductor module 500 shown in FIG. 3C.

The sub-module 200 according to the embodiment can include a plurality of power semiconductor devices 100a and 100b disposed between a first internal conductive frame 210 and a second internal conductive frame 220, and an inner mold 201 surrounding the side surfaces of the plurality of power semiconductor devices 100a, 100b. The first internal conductive frame 210 can include a first-first internal conductive frame 210a and a first-second internal conductive frame 210 b.

The first-first internal conductive frame 210a can be electrically connected to the drain electrode of the first power semiconductor device 100a, and the first-second internal conductive frame 210b can be electrically connected to the source electrode and the gate electrode of the second power semiconductor device 100b. The first-second internal conductive frame 210b connected to the gate electrode and the source electrode of the second power semiconductor device 100b can have separate elements not be connected to each other unlike the drawings.

The second internal conductive frame 220 can be electrically connected to the gate electrode and the source electrode of the first power semiconductor device 100a, and can be electrically connected to the drain electrode of the second power semiconductor device 100b. Unlike the drawings, the second internal conductive frame 220 connected to the gate electrode and the source electrode of the first power semiconductor device 100a is not be connected to each other but can have separate elements.

The inner mold 201 can perform a function of protecting the plurality of power semiconductor devices 100a and 100b from an oxide material and fixing the plurality of power semiconductor devices 100a and 100b.

According to the embodiment, in the sub-module step using the first and second internal conductive frames 210 and 220, primary first molding can be performed through the first mold 201, so there are technical effects that can solving the problem of generating of voids inside.

Also, according to the embodiment, a plurality of power semiconductor devices can be sub-modules using an internal conductive frame. In the sub-module state, the internal conductive frame can be bonded to the first substrate 410 and the second substrate 420, and the power semiconductor device can be protected by the first mold 201. Accordingly, there is a technical effect that can solve the problem that the power semiconductor device is cracked.

In addition, the embodiment proceeds with a sub module using an internal conductive frame, and since the internal conductive frame in a sub module state is adhered to the first and second substrates 410 and 420, the electrodes of the power semiconductor device and the first and second substrates are bonded. So, there is a technical effect that can solve the problem of electrical interconnection failure between the conductive layer patterns of the second substrates 410 and 420.

In addition, according to the embodiment, a plurality of power semiconductor elements can be serialized or parallelized into submodules according to module specifications, so that the number of devices to be loaded can be adjusted. In addition, only failed submodules can be discarded through pre-testing of submodules, so the embodiment has a technical effect of reducing costs and increasing mass productivity.

Next, FIGS. 4A to 4G are views illustrating manufacturing processes of the power semiconductor module 500 according to the embodiment.

First, referring to FIG. 4A, a plurality of power semiconductor devices 100 can be disposed on the first internal conductive frame 210. The first internal conductive frame 210 can be a conductive metal layer including Cu or the like.

The power semiconductor device 100 can be packaged in a plurality in a parallel form in which each electrode is disposed in the same direction, or can be packaged in a form in which each electrode is disposed in opposite directions to form each arm.

In addition, the embodiment can also include a diode-type power semiconductor device in addition to a MOSFET-type power semiconductor device, and diodes (not shown) can be disposed in parallel with each power semiconductor device 100 or can also be arranged in the form of internal diodes to each power semiconductor device.

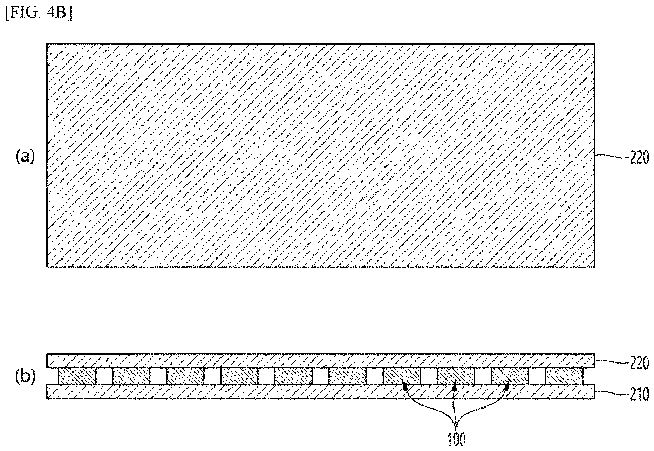

Next, as shown in FIG. 4B, a second internal conductive frame 220 can be disposed on the plurality of power semiconductor devices 100. The second internal conductive frame 220 can be a conductive metal layer including Cu or the like.

In FIG. 4B, the first internal conductive frame 210 and the second internal conductive frame 220 are illustrated, but are not limited thereto.

For example, the sub-module 200 of the embodiment can include at least one of the first internal conductive frame 210 and the second internal conductive frame 220. For example, the sub-module 200 of the embodiment cannot have an internal frame located in the direction of the drain electrode of the power semiconductor device 100, in which case the drain electrode can be electrically connected by contacting the electrode pattern of the first substrate or the second substrate.

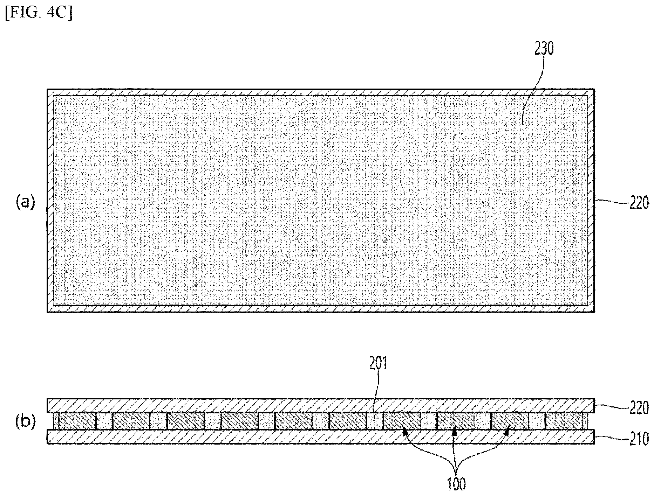

Next, as shown in FIG. 4C, a first mold 201 can be filled between the first internal conductive frame 210 and the second internal conductive frame 220.

According to the embodiment, in the sub-module step using the first and second internal conductive frames 210 and 220, primary first molding can be performed through the first mold 201, so there are technical effects that can solving the problem of generating of voids inside.

In addition, according to the embodiment, a plurality of power semiconductor devices can be sub-modules using internal conductive frames, and in the sub-module state, the internal conductive frames are bonded to the first substrate 410 and the second substrate 420. Since the power semiconductor device is protected by the inner mold 201, there is a technical effect of solving the problem of cracking the power semiconductor device.

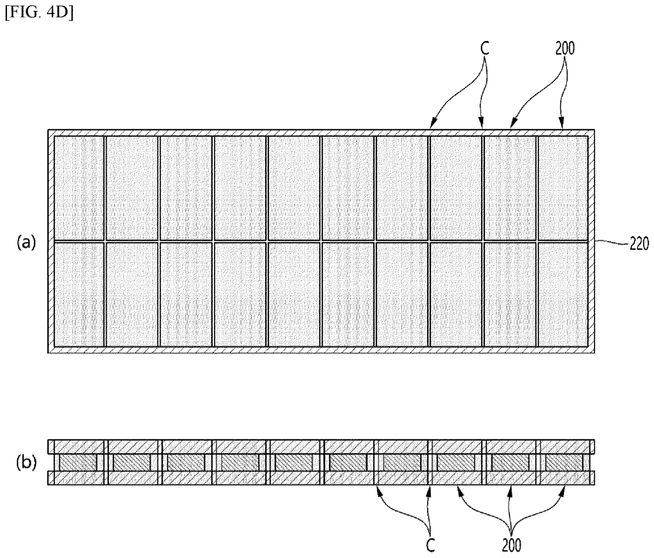

Next, as shown in FIG. 4D, the sub-module 200 can be manufactured by performing singulation C on the internally molded 201 module.

The sub-module 200 can include a plurality of power semiconductor devices 100. The electrodes of each power semiconductor element 100 can be packaged in a parallel form facing the same direction, or can be packaged in a form in which each electrode is arranged in opposite directions to form each arm.

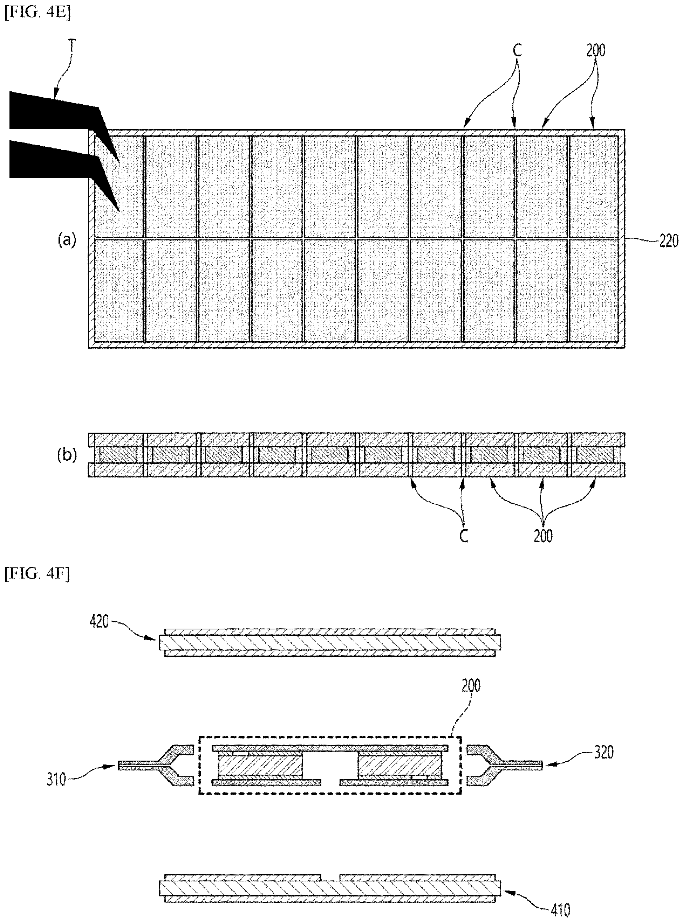

Next, as shown in FIG. 4E, a pre-test can be performed for each sub-module 200.

According to the embodiment, a plurality of power semiconductor elements can be serialized or parallelized into submodules according to module specifications, so that the number of devices to be loaded can be adjusted. In addition, only failed submodules can be discarded through pre-testing of submodules, so the embodiment has a technical effect of reducing costs and increasing mass productivity.

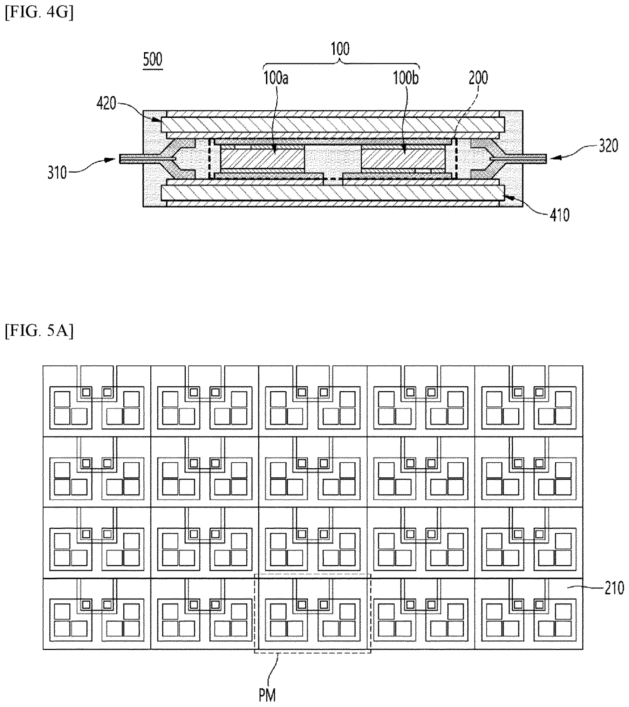

Next, as shown in FIGS. 4F and 4G, the first conductive frame 310, the second conductive frame 320, and the sub-module 200 can be disposed between the first substrate 410 and the second substrate 420, and the power semiconductor module 500 according to the embodiment can be manufactured after pressing.

Accordingly, according to the embodiment, a plurality of power semiconductor devices can be sub-modules using internal conductive frames, and in the sub-module state, the internal conductive frames are bonded to the first substrate 410 and the second substrate 420. Since the power semiconductor device is protected by the inner mold 201, there is a technical effect of solving the problem of cracking the power semiconductor device.

In addition, the embodiment proceeds with a sub module using an internal conductive frame, and since the internal conductive frame in a sub module state is adhered to the first and second substrates 410 and 420, the electrodes of the power semiconductor device and the first and second substrates are bonded. So, there is a technical effect that can solve the problem of electrical interconnection failure between the conductive layer patterns of the second substrates 410 and 420.

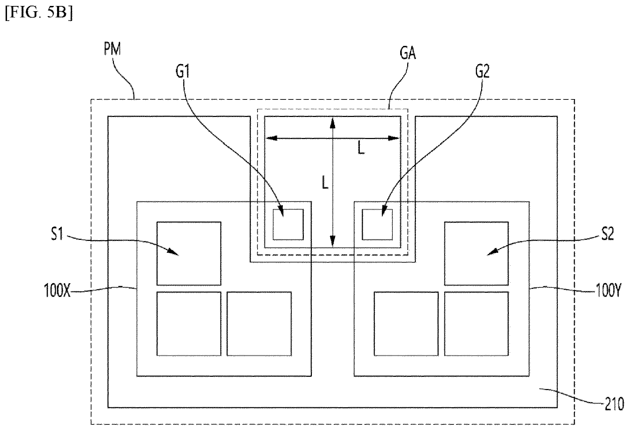

Next, FIG. 5A is an exemplary view of a manufacturing process of a second sub-module PM according to a second embodiment, and FIG. 5B is an enlarged view of the second sub-module PM disposed on the first internal conductive frame shown in FIG. 5A.

The second embodiment can adopt technical features of the above-described embodiment, and the main features of the second embodiment will be mainly described below.

Referring to FIG. 5B, the second sub-module PM can include a second-first power semiconductor device 100X and a second-second power semiconductor device 100Y disposed on the first internal conductive frame 210.

The second-first power semiconductor device 100X can include a second-first source region S1 and a second-first gate region G1. The second-second power semiconductor device 100Y can include a second-second source region S2 and a second-second gate region G2.

The second-first source region S1 and the second-second source region S2 can include a plurality of spaced apart source regions, but are not limited to. The source regions spaced apart from each source electrode can be electrically connected in a subsequent process.

The second sub-module PM has a technical effect of securing a wide second gate electrode area GA.

For example, a width L of one side of the second gate electrode area GA can be secured four times or more than that of the first gate area G1 or the second gate area G2. Accordingly, there is a special technical effect of securing a gate electrode area 16 times (L×L) or more in the second gate electrode area GA compared to the internal technology.

Although the above has been described with reference to the embodiments of the present invention, those skilled in the art will variously modify the present invention within the scope not departing from the scope of the present invention described in the claims below. And it will be readily understood that it can be changed.

## Claims

1. A power semiconductor module, comprising:
a first substrate and a second substrate;
a sub-module disposed between the first substrate and the second substrate; and
a first conductive frame and a second conductive frame electrically connected to the sub-module;
wherein the sub-module comprises:
a power semiconductor device disposed between a first internal conductive frame and a second internal conductive frame; and
a first mold disposed between the first internal conductive frame and the second internal conductive frame, and disposed on a side surface of the power semiconductor device.

2. The power semiconductor module according to claim 1, wherein the power semiconductor device comprises first and second power semiconductor devices, and
wherein the first internal conductive frame comprises a first-first internal conductive frame and a first-second internal conductive frame spaced apart each other.

3. The power semiconductor module according to claim 2, wherein the first-first internal conductive frame is electrically connected to a drain electrode of the first power semiconductor device, and/or
wherein the first-second internal conductive frame is electrically connected to a source electrode and a gate electrode of the second power semiconductor device.

4. The power semiconductor module according to claim 2 or 3, wherein the second internal conductive frame is electrically connected to a gate electrode and a source electrode of the first power semiconductor device, and electrically connected to a drain electrode of the second power semiconductor device.

5. The power semiconductor module according to any one of the preceding claims, wherein the first substrate comprises a first metal layer, a first insulating layer, and a second metal layer sequentially disposed, and
wherein the second metal layer comprises a second-first metal layer and a second-second metal layer electrically separated from each other.

6. The power semiconductor module according to claim 5, wherein each of the second-first metal layer and the second-second metal layer is electrically connected to each of the first-first internal conductive frame and the first-second internal conductive frame spaced apart from each other of the sub-module.

7. The power semiconductor module according to claim 5 or 6 in combination with claim 2, wherein each of the second-first metal layer and the second-second metal layer is in contact with the first-first internal conductive frame and the first-second internal conductive frame spaced apart from each other of the sub-module.

8. The power semiconductor module according to any one of the preceding claims, wherein the second substrate comprises a third metal layer, a second insulating layer, and a fourth metal layer sequentially disposed, and
wherein the third metal layer is electrically connected to the second internal conductive frame of the sub-module.

9. The power semiconductor module according to claim 8, wherein the third metal layer is in contact with the second internal conductive frame of the sub-module.

10. The power semiconductor module according to any one of the preceding claims, wherein the first conductive frame and the second conductive frame are electrically connected to the sub-module through the first substrate and the second substrate, respectively.

11. The power semiconductor module according to claim 10, wherein the first conductive frame comprises:
a first-first conductive frame electrically connected to the second-first metal layer of the first substrate; and/or
a first-second conductive frame electrically connected to the third metal layer of the second substrate.

12. The power semiconductor module according to claim 10 or 11, wherein the second conductive frame comprises:
a second-first conductive frame electrically connected to the second-second metal layer of the first substrate; and/or
a second-second conductive frame electrically connected to the third metal layer of the second substrate.

13. The power semiconductor module according to any one of the preceding claims, further comprising a second mold surrounding an outer surface of the sub-module.

14. A power converter comprising the power semiconductor module according to any one of the preceding claims.

15. A manufacturing method of a power semiconductor module, the manufacturing method comprising:
forming a first substrate;
forming a molded sub-module on a top of the first substrate;
forming a second substrate on a top of the molded sub-module;
electrically connecting a first conductive frame to the molded sub-module; and
electrically connecting a second conductive frame to the molded sub-module,
wherein the molded sub-module comprises:
a first internal conductive frame;
a second internal conductive frame;
a semiconductor device disposed between the first internal conductive frame and the second internal conductive frame; and
a first mold disposed between the first, second internal conductive frames and on a side surface of the semiconductor device.
